# FASCICULE DE BREVET EUROPEEN

(11) **EP 2 680 101 B1**
(45) Date de publication et mention de la délivrance du brevet: **14.09.2016**
(21) Numéro de dépôt: 13174216.5
(22) Date de dépôt: 28.06.2013
(51) Int. Cl.: G06F 1/16, G06F 3/02, H03K 17/96, G05D 1/00, B62D 15/02, G06F 1/32

(54) **Dispositif de manoeuvre automatique comprenant un boîtier de commande à distance**
Automatische Bedienungsvorrichtung, die ein Fernbedienungsgehäuse umfasst
Automatic operation device comprising a remote control housing

(30) Priorité: 29.06.2012 FR 1201845
(43) Date de publication de la demande: 01.01.2014
(73) Titulaire: Valeo Comfort and Driving Assistance, 94046 Créteil Cedex (FR)
(72) Inventeur: Menard, Eric, 94046 Créteil CEDEX (FR)
(74) Mandataire: Pothmann, Karsten

(56) Documents cités:
- EP-A1- 2 323 354
- EP-A1- 2 434 645
- JP-A- 2004 031 018
- JP-A- 2008 033 438

## Description

Les modes de réalisation de la présente invention concernent un dispositif de manoeuvre automatique d'un véhicule automobile et plus particulièrement un boîtier de commande à distance d'un tel dispositif.

Afin de faciliter les manoeuvres liées au parcage des véhicules automobiles, les constructeurs ont développés différents systèmes d'assistance au parcage ou de parcage automatique du véhicule. Dans ces systèmes automatiques, le parcage est réalisé de manière autonome par le véhicule à l'aide de capteurs et de calculateurs qui permettent de définir la manoeuvre à réaliser pour garer le véhicule sur une place de stationnement sélectionnée. De plus, afin d'éviter tout accident lors du parcage automatique, l'utilisateur du véhicule doit pouvoir, à tout moment et de manière fiable, interrompre le parcage automatique du véhicule. Ainsi, des télécommandes ont été développées pour permettre une telle interruption. Cependant, dans les télécommandes de l'état de la technique, la commande de parcage est réalisée par un interrupteur mécanique. Or, avec de tels interrupteurs, un blocage mécanique pourrait entrainer le non-arrêt du véhicule et conduire à un accident.

On connaît également, le document JP-2008 033438 A, qui divulgue un boîtier de commande à distance d'un dispositif de manoeuvre automatique d'un véhicule automobile dans le lequel au niveau du bouton de commande est disposé un système de vérification d'empreinte digitale. Néanmoins, un tel dspositif est assez complexe, coûteux, et manque de flexibilité.

Afin de surmonter au moins partiellement les inconvénients précités de l'état de la technique et proposer une solution permettant d'interrompre de manière fiable le parcage automatique d'un véhicule, il convient de fiabiliser le fonctionnement de la commande de parcage.

Ainsi, la présente invention propose un boîtier de commande à distance d'un dispositif de manoeuvre automatique d'un véhicule automobile selon les caractéristiques de la revendication 1.

Selon un aspect additionnel de la présente invention, la zone périphérique est circulaire ou oblongue et correspond sensiblement à la taille d'un doigt.

Selon un aspect supplémentaire de la présente invention, les moyens d'inhibition sont configurés pour mesurer une valeur initiale délivrée par le capteur capacitif lorsque l'élément de commande passe de sa position de repos à sa position active puis pour mesurer les valeurs suivantes délivrées par le capteur capacitif pendant que l'élément de commande est en position active et si l'écart entre les valeurs suivantes et la valeur initiale dépasse un seuil prédéterminé, la commande de manoeuvre par ledit élément de commande est inhibée.

Selon un aspect additionnel de la présente invention, les moyens de contrôle sont configurés pour mesurer les valeurs délivrées par le capteur capacitif lorsque l'interrupteur est dans une position enfoncée et pour comparer les valeurs mesurées à un seuil prédéterminé et si une valeur mesurée est inférieure au seuil prédéterminé, la commande de manoeuvre par ledit élément de commande est inhibée.

Les modes de réalisation de la présente invention concernent également un dispositif de manoeuvre automatique comprenant un boîtier de commande à distance.

Les modes de réalisation de la présente invention concernent également un véhicule automobile comprenant un dispositif de manoeuvre automatique.

D'autres caractéristiques et avantages de l'invention apparaîtront dans la description qui va maintenant en être faite, en référence aux dessins annexés qui en représentent, à titre indicatif mais non limitatif, un mode de réalisation possible.

Sur ces dessins:
- la figure 1 représente un schéma de l'unité centrale et du boîtier de commande d'un dispositif de parcage d'un véhicule automobile;
- la figure 2 représente un schéma d'un parking;
- la figure 3 représente un schéma de la manoeuvre de parcage automatique du véhicule dans le parking de la figure 2 ;
- la figure 4 représente un schéma de la présence d'un piéton sur la trajectoire du véhicule lors d'un parcage automatique ;
- la figure 5 représente un schéma du véhicule garé après une manoeuvre de parcage automatique ;

Sur toutes les figures, les éléments identiques portent les mêmes numéros de référence.

Les modes de réalisation de la présente invention concernent un dispositif de manoeuvre automatique d'un véhicule automobile comprenant un boîtier de commande à distance destiné à enclencher la manoeuvre automatique par l'appui sur un élément de commande comme un interrupteur et à interrompre la manoeuvre automatique à tout moment en relâchant l'élément de commande. La manoeuvre automatique correspond à un parcage ou à un déparcage automatique du véhicule.

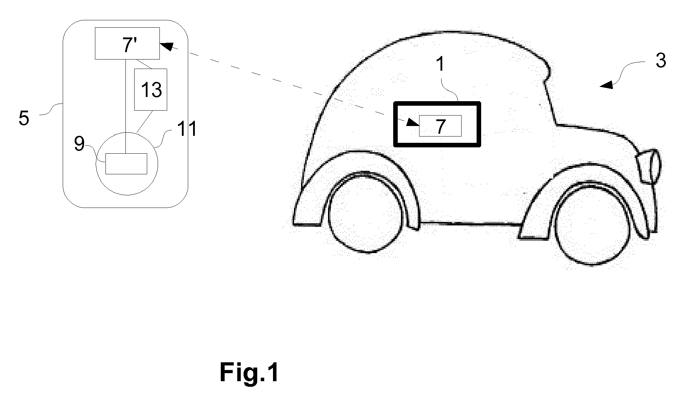

La figure 1 montre un schéma d'un tel dispositif comprenant une unité centrale 1 située dans le véhicule automobile 3 et un boîtier de commande à distance 5 réalisé par exemple sous la forme d'une télécommande ou d'un téléphone portable. L'unité centrale 1 et le boîtier de commande 5 comprennent respectivement des moyens de communication 7 et 7', par exemple des moyens de communication radio-fréquences, pour transmettre des signaux entre le boîtier de commande 5 et l'unité centrale 1. L'unité centrale 1 gère les différents éléments nécessaires à la manoeuvre automatique du véhicule automobile 3 comme par exemple :
- les signaux issus des capteurs de proximité, généralement des capteurs à ultrasons situés au niveau des pare-chocs,
- les moyens de commande du moteur ou,
- les moyens de commande de la direction du véhicule.

Le parcage automatique du véhicule peut comprendre plusieurs modes de commande du parcage automatique, par exemple un mode de commande intérieur dans lequel l'utilisateur reste sur le siège conducteur durant la manoeuvre de parcage, le parcage est alors piloté par un appui sur l'accélérateur et interrompu par un appui sur le frein et un mode de commande extérieur dans lequel l'utilisateur peut être situé hors du véhicule durant la manoeuvre et dans lequel l'utilisateur utilise le boîtier de commande à distance 5 pour piloter ou interrompre le parcage automatique du véhicule automobile 3.

Le boîtier de commande 5 comprend un élément de commande 9 qui peut prendre une position active qui commande le parcage automatique du véhicule automobile 3 et une position de repos dans laquelle aucune commande de parcage automatique du véhicule automobile 3 n'est envoyée. Ainsi, si un parcage automatique est enclenché par appui sur l'élément de commande 9, le relâchement du bouton de commande entraîne l'arrêt du parcage automatique même si la manoeuvre ne parcage n'est pas terminée. Selon un mode de réalisation, l'élément de commande 9 est un interrupteur qui peut être réalisé sous la forme d'un bouton poussoir dont la position active est la position enfoncée et dont la position de repos est la position relâchée. Ainsi, lorsque le dispositif de parcage automatique est dans un mode extérieur contrôlé par le boîtier de commande 5, le parcage automatique n'est réalisé que lorsque l'utilisateur maintient l'élément de commande 9 en position active, c'est-à-dire, le bouton poussoir enfoncé. De plus, le boîtier de commande 5 comprend également un capteur de présence 11 au niveau de l'élément de commande 9 pour détecter la présence d'un doigt d'un utilisateur au niveau de l'élément de commande. Ce capteur de présence est par exemple un capteur capacitif qui détecte la présence du doigt de l'utilisateur lorsque l'interrupteur est enfoncé et qui ne détecte aucune présence lorsque l'interrupteur est relâché. Il est à noter que le capteur capacitif 11 détecte non seulement un doigt mais également tout autre élément appuyant sur l'élément de commande 5. Le capteur capacitif 11 est positionné dans une zone périphérique à l'élément de commande. Dans le mode de réalisation représenté, la zone sensible du capteur capacitif est délimitée par un cercle sensiblement de la taille de la circonférence d'un doigt, cependant, la forme de la zone sensible peut également être oblongue.
Le capteur capacitif 11 est relié à des moyens d'inhibition 13 de la commande du parcage automatique. Ces moyens d'inhibition 13 sont configurés de sorte que lorsqu'aucune présence est détectée par le capteur de présence 11, les moyens de communication 7' du boîtier de commande 5 ne peuvent pas transmettre de signal de commande du parcage automatique vers l'unité centrale 1. Ainsi, pour transmettre un signal de commande à l'unité centrale 1, il faut d'une part que l'élément de commande 9 soit dans une position active et que le capteur de présence 11 détecte la présence d'un doigt d'un utilisateur. Lorsque l'utilisateur relâche le bouton poussoir 9, même si ce dernier reste bloqué dans une position enfoncée, le capteur de présence 11 ne détecte plus de présence du doigt de l'utilisateur de sorte que le moyens d'inhibition 13 empêchent l'envoi d'un signal de commande vers l'unité centrale 1 ce qui empêche tout parcage automatique du véhicule automobile 3 depuis le boîtier de commande 5.

Selon un premier mode de réalisation, les moyens d'inhibition 13 sont configurés pour réaliser une mesure initiale de la valeur délivrée par le capteur de capacitif 11 lorsque l'élément de commande 9 passe dans une position active puis pour déterminer l'évolution au cours du temps de la valeur de capacité fournie par le capteur capacitif 11, par exemple en réalisant des mesures à une fréquence prédéterminée, et lorsque l'écart entre une valeur mesurée et la valeur initiale dépasse un seuil prédéterminé, les moyens d'inhibition 13 empêchent l'envoi d'une commande de parcage vers l'unité centrale 1. Le seuil prédéterminé étant fixé de manière à être dépassé lorsque l'utilisateur relâche l'élément de commande 9. Les mesures sont réalisées tant que l'élément de commande 9 reste dans une position active ou jusqu'à ce que le parcage automatique soit achevé.

Selon un deuxième mode de réalisation, les moyens d'inhibition 13 sont configurés pour mesurer la valeur de capacité fournie par le capteur capacitif 11 lorsque l'élément de commande 9 est dans une position active et pour comparer les valeurs mesurées avec un seuil prédéterminé et lorsqu'une valeur mesurée est inférieure au seuil prédéterminé, les moyens d'inhibition 13 empêchent l'envoi d'une commande de parcage vers l'unité centrale. Le seuil prédéterminé étant fixé de manière à être situé entre la valeur de capacité correspondant à une position relâchée et la valeur de capacité correspondant à une position active de l'élément de commande 9. Les mesures sont réalisées tant que l'élément de commande 9 reste dans une position active ou jusqu'à ce que le parcage automatique soit achevé.

Lorsque la manoeuvre de parcage automatique est achevée, l'unité centrale envoie un signal au boîtier de commande afin d'avertir l'utilisateur, par exemple par un signal sonore et/ou lumineux que la manoeuvre de parcage est terminée et qu'il peut relâcher l'élément de commande.

Afin de mieux comprendre la présente invention, un exemple d'utilisation d'un boîtier de commande d'un dispositif de parcage automatique va maintenant être décrit en détail.

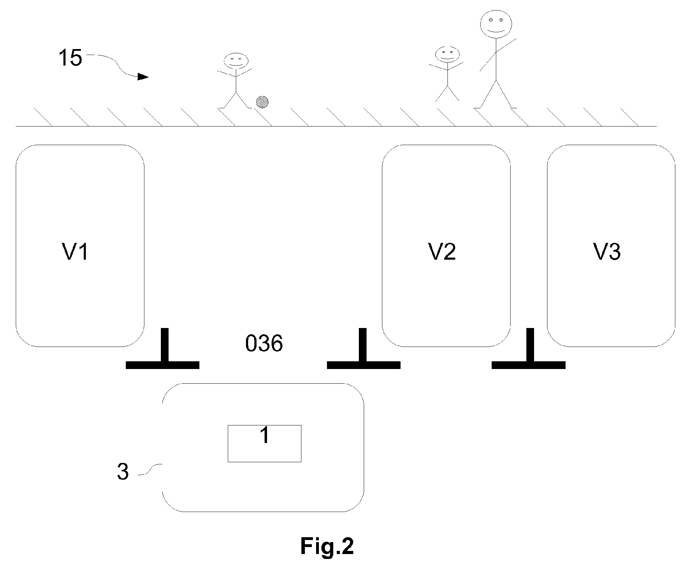

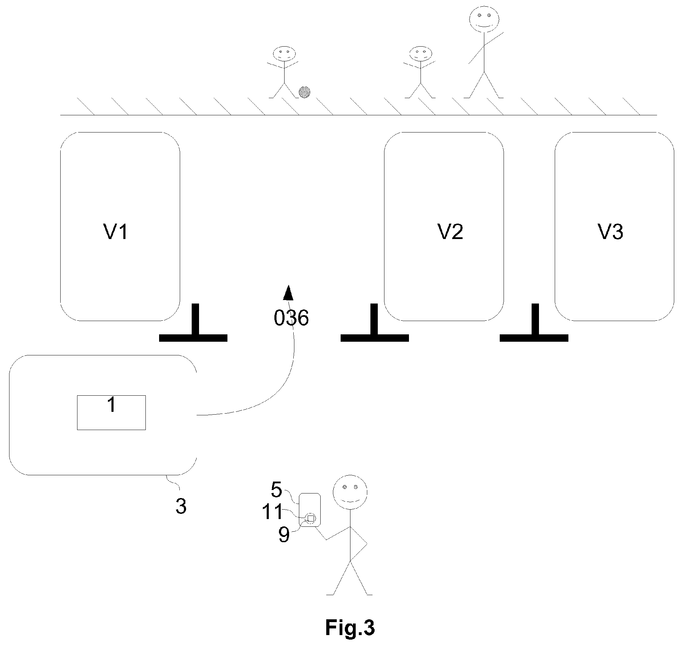

La figure 2 représente un véhicule automobile 3 muni d'un dispositif de parcage automatique. L'unité centrale 1 du dispositif de parcage automatique comprend également des moyens de détection d'une place de stationnement appropriée à la taille du véhicule automobile 3. Ainsi, l'utilisateur du véhicule automobile 3, M. Martin, enclenche le mode de détection d'une place de stationnement et circule dans un parking comprenant des véhicules stationnés notés V1, V2 et V3 et qui longe un trottoir 15 sur lequel se trouvent des piétons. Le dispositif de parcage automatique détecte alors l'emplacement 036 comme ayant une taille suffisante pour effectuer un parcage automatique. M. Martin stoppe alors son véhicule 3 devant l'emplacement 036, enclenche le mode extérieur de parcage automatique puis descend de son véhicule muni de son boîtier de commande 5. Une fois à l'extérieur du véhicule, M. Martin appuie sur l'élément de commande 9 de son boîtier de commande 5. La mesure initiale de capacité délivrée par le capteur de présence capacitif 11 est alors effectuée et un signal de commande de parcage automatique est envoyé à l'unité centrale 1 située au niveau du véhicule 3. L'unité centrale 1 enclenche alors la manoeuvre de parcage automatique comme représenté sur la figure 3.

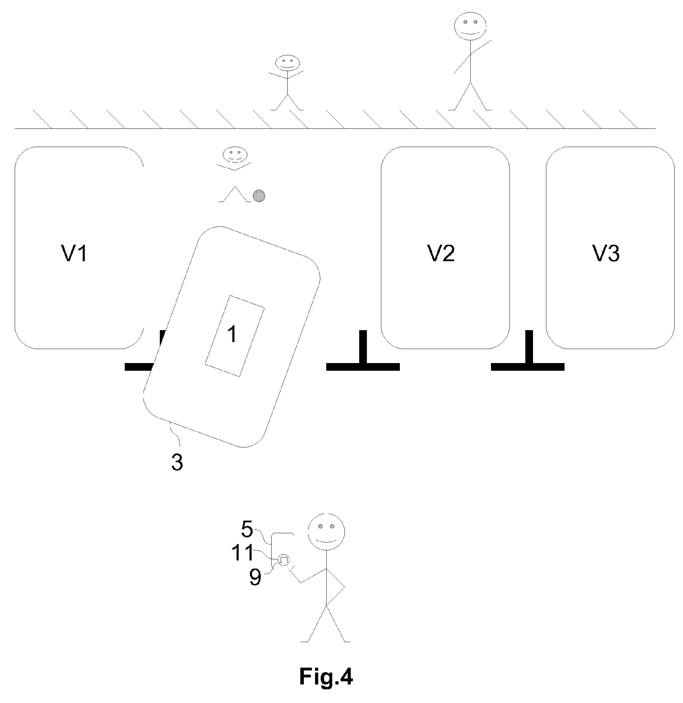

Pendant la manoeuvre de parcage, un piéton, par exemple un enfant, descend du trottoir sur l'emplacement 036 pour récupérer son ballon comme représenté sur la figure 4. Afin d'éviter un choc entre l'enfant et le véhicule 3, M. Martin relâche l'élément de commande 9. L'écart entre la valeur de capacité mesurée et la valeur initiale est alors supérieure au seuil prédéterminé de sorte que les moyens d'inhibition empêchent l'envoi du signal du commande du boîtier de commande 5 vers l'unité centrale 1 ce qui interrompt la manoeuvre de parcage même si l'élément de commande 9, c'est-à-dire le bouton poussoir est resté en position enfoncé.

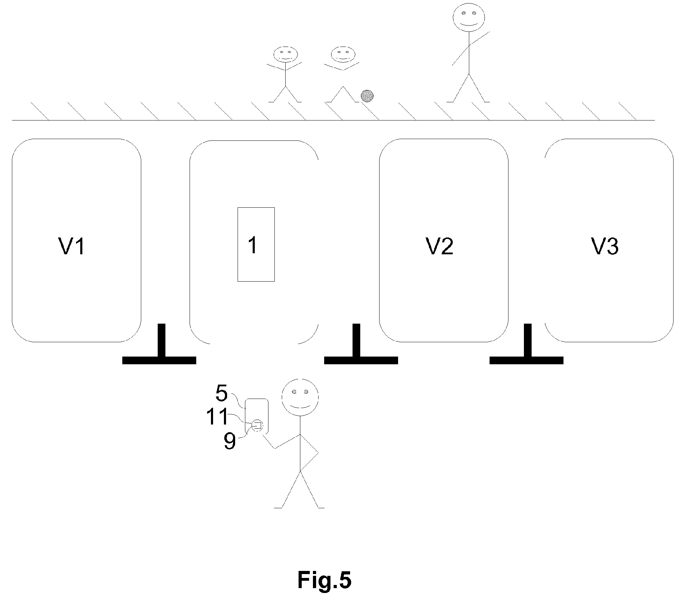

Par ailleurs, il est à noter que la présence d'un enfant ou tout autre objet est également détectée par les capteurs de proximité situés sur le véhicule de sorte que le boîtier de commande 5 constitue une sécurité supplémentaire pour empêcher tout accident. Une fois que l'enfant n'est plus sur l'emplacement 036, M. Martin peut reprendre la manoeuvre de parcage automatique en appuyant à nouveau sur l'élément de commande de son boîtier jusqu'à ce que la manoeuvre soit terminée et le véhicule garé comme représenté sur la figure 5.

De plus, de la même manière que pour le parcage automatique, le boîtier de commande peut permettre d'effectuer un déparcage automatique par appui sur un élément de contrôle du boîtier de commande, un relâchement de l'élément de commande pendant le déparcage étant détecté par le capteur de présence ce qui empêche la transmission de tout signal de commande de déparcage de sorte que le déparcage est interrompu.

Ainsi, les modes de réalisation de la présente invention permettent d'assurer une très grande sécurité en réduisant les risques de dysfonctionnement d'un boîtier de commande à distance destiné à commander le parcage ou le déparcage automatique d'un véhicule automobile. En effet, l'utilisation d'un capteur de présence permet de surmonter tout problème lié au blocage mécanique qui pourrait avoir lieu au niveau du bouton-poussoir constituant l'élément de commande. De plus, un tel capteur ne modifie pas le fonctionnement du boîtier de commande pour l'utilisateur.

## Revendications

1. Boîtier de commande à distance (5) d'un dispositif de manoeuvre automatique d'un véhicule automobile (3) comprenant une unité centrale (1) située au niveau du véhicule automobile (3), ledit boîtier (5) étant destiné à communiquer avec l'unité centrale (1) et étant équipé d'un élément de commande (9) de manoeuvre automatique, de type interrupteur réalisé sous la forme d'un bouton-poussoir, pouvant prendre une position active qui commande la manoeuvre automatique et une position de repos, ladite position active correspondant à une position enfoncée sous l'effet de la pression du doigt d'un utilisateur et la position de repos correspondant à une position relâchée, ledit boîtier (5) comprenant également un capteur de présence (11) au niveau dudit élément de commande (9) configuré pour détecter la présence d'un doigt d'un utilisateur, ledit boîtier (5) comprenant des moyens d'inhibition (13) d'une commande de manoeuvre par ledit élément de commande (9) lorsqu'aucune présence est détectée par ledit capteur de présence (11), **caractérisé en ce que** le capteur de présence (11) est un capteur capacitif couvrant une zone périphérique à l'élément de commande (9), configuré pour détecter la présence du doigt d'un utilisateur au niveau de l'élément de commande (9).

2. Boîtier de commande à distance (5) selon la revendication 1 dans lequel la zone périphérique est circulaire ou oblongue et correspond sensiblement à la taille d'un doigt.

3. Boîtier de commande à distance (5) selon l'une des revendications 1 ou 2 dans lequel les moyens d'inhibition (13) sont configurés pour mesurer une valeur initiale délivrée par le capteur capacitif (11) lorsque l'élément de commande (9) passe d'une position de repos à une position active puis pour mesurer les valeurs suivantes délivrées par le capteur capacitif (11) pendant que l'élément de commande (9) est en position active et si l'écart entre les valeurs suivantes et la valeur initiale dépasse un seuil prédéterminé, la commande de manoeuvre par ledit élément de commande (9) est inhibée.

4. Boîtier de commande à distance (5) selon l'une des revendications 1 ou 2 dans lequel les moyens d'inhibition sont configurés pour mesurer les valeurs délivrées par le capteur capacitif (11) lorsque l'élément de commande est dans une position active et pour comparer les valeurs mesurées à un seuil prédéterminé et si une valeur mesurée est inférieure au seuil prédéterminé, la commande de manoeuvre par ledit élément de commande (9) est inhibée.

5. Boîtier selon l'une des revendications précédentes dans lequel la manoeuvre automatique est une manoeuvre automatique de parcage ou de déparcage.

6. Dispositif de manoeuvre automatique comprenant un boîtier de commande (9) à distance selon l'une des revendications précédentes.

7. Véhicule automobile (3) comprenant un dispositif de manoeuvre automatique selon la revendication 6.

## Patentansprüche

1. Fernsteuerungsgehäuse (5) einer Vorrichtung zum automatischen Manövrieren eines Kraftfahrzeugs (3), die eine im Bereich des Kraftfahrzeugs (3) befindliche zentrale Einheit (1) enthält, wobei das Gehäuse (5) dazu bestimmt ist, mit der zentralen Einheit (1) zu kommunizieren und mit einem Steuerelement (9) zum automatischen Manövrieren von der Art eines in Form einer Drucktaste hergestellten Schalters ausgestattet ist, welches eine aktive Stellung, die das automatische Manövrieren steuert, und eine Ruhestellung einnehmen kann, wobei die aktive Stellung einer unter der Wirkung des Drucks des Fingers eines Benutzers eingedrückten Stellung und die Ruhestellung einer losgelassenen Stellung entspricht, wobei das Gehäuse (5) ebenfalls einen Präsenzsensor (11) im Bereich des Steuerelements (9) enthält, der konfiguriert ist, die Präsenz eines Fingers eines Benutzers zu erfassen, wobei das Gehäuse (5) Sperreinrichtungen (13) einer Manövriersteuerung durch das Steuerelement (9) enthält, wenn keine Präsenz durch den Präsenzsensor (11) erfasst wird, **dadurch gekennzeichnet, dass** der Präsenzsensor (11) ein kapazitiver Sensor ist, der eine Randzone des Steuerelements (9) abdeckt, konfiguriert, die Präsenz des Fingers eines Benutzers im Bereich des Steuerelements (9) zu erfassen.

2. Fernsteuerungsgehäuse (5) nach Anspruch 1, wobei die Randzone kreisförmig oder länglich ist und im Wesentlichen der Größe eines Fingers entspricht.

3. Fernsteuerungsgehäuse (5) nach einem der Ansprüche 1 oder 2, wobei die Sperreinrichtungen (13) konfiguriert sind, einen vom kapazitiven Sensor (11) gelieferten Ausgangswert zu messen, wenn das Steuerelement (9) von einer Ruhestellung in eine aktive Stellung übergeht, dann die folgenden vom kapazitiven Sensor (11) gelieferten Werte zu messen, während das Steuerelement (9) in der aktiven Stellung ist, und wenn die Abweichung zwischen den folgenden Werten und dem Ausgangswert eine vorbestimmte Schwelle überschreitet, die Manövriersteuerung durch das Steuerelement (9) gesperrt wird.

4. Fernsteuerungsgehäuse (5) nach einem der Ansprüche 1 oder 2, wobei die Sperreinrichtungen konfiguriert sind, die vom kapazitiven Sensor (11), wenn das Steuerelement in einer aktiven Stellung ist, gelieferten Werte zu messen, und die gemessenen Werte mit einer vorbestimmten Schwelle zu vergleichen, und wenn ein gemessener Wert unter der vorbestimmten Schwelle liegt, die Manövriersteuerung durch das Steuerelement (9) gesperrt wird.

5. Gehäuse nach einem der vorhergehenden Ansprüche, wobei das automatische Manövrieren ein Manövrieren zum Ein- oder Ausparken ist.

6. Automatische Manövriervorrichtung, die ein Fernsteuerungsgehäuse (9) nach einem der vorhergehenden Ansprüche enthält.

7. Kraftfahrzeug, das eine automatische Manövriervorrichtung nach Anspruch 6 enthält.

## Claims

1. Remote control housing (5) of an automatic operation device of a motor vehicle (3) comprising a central unit (1) situated in the motor vehicle (3), said housing (5) being intended to communicate with the central unit (1) and being equipped with an automatic operation control element (9), of switch type produced in the form of a push button, that can assume an active position which controls the automatic operation and a rest position, said active position corresponding to a depressed position under the effect of the pressure of the finger of a user and the rest position corresponding to a released position, said housing (5) also comprising a presence sensor (11) on said control element (9) configured to detect the presence of a finger of a user, said housing (5) comprising means (13) for disabling an operation command by said control element (9) when no presence is detected by said presence sensor (11), **characterized in that** the presence sensor (11) is a capacitive sensor covering a zone peripheral to the control element (9), configured to detect the presence of the finger of a user on the control element (9).

2. Remote control housing (5) according to Claim 1, in which the peripheral zone is circular or oblong and corresponds substantially to the size of a finger.

3. Remote control housing (5) according to one of Claims 1 or 2, in which the disabling means (13) are configured to measure an initial value delivered by the capacitive sensor (11) when the control element (9) switches from a rest position to an active position, then to measure the subsequent values delivered by the capacitive sensor (11) while the control element (9) is in active position and if the deviation between the subsequent values and the initial value exceeds a predetermined threshold, the operation command by said control element (9) is disabled.

4. Remote control housing (5) according to one of Claims 1 or 2, in which the disabling means are configured to measure the values delivered by the capacitive sensor (11) when the control element is in an active position and to compare the measured values to a predetermined threshold and if a measured value is below the predetermined threshold, the operation command by said control element (9) is disabled.

5. Housing according to one of the preceding claims, in which the automatic operation is an automatic park or park release operation.

6. Automatic operation device comprising a remote control housing (9) according to one of the preceding claims.

7. Motor vehicle (3) comprising an automatic operation device according to Claim 6.
